Europäisches Patentamt

(19) European Patent Office

Office européen des brevets

(11) Publication number: **0 242 391 B1**

## (12) EUROPEAN PATENT SPECIFICATION

(45) Date of publication of patent specification:
04.09.91 Bulletin 91/36

(51) Int. Cl.⁵: **B63G 9/06**, G01V 3/15

(21) Application number: 86906367.7

(22) Date of filing: 16.10.86

(86) International application number:
PCT/GB86/00624

(87) International publication number:
WO 87/02324 23.04.87 Gazette 87/09

(54) **A MAGNETIC SELF-RANGING SYSTEM FOR USE IN THE DEGAUSSING OF SHIPS.**

(30) Priority: 18.10.85 GB 8525742

(43) Date of publication of application:
28.10.87 Bulletin 87/44

(45) Publication of the grant of the patent:
04.09.91 Bulletin 91/36

(84) Designated Contracting States:
DE FR GB IT NL SE

(56) References cited:
EP-A- 0 133 408
WO-A-80/02017
DE-A- 3 132 932
US-A- 2 405 595
US-A- 2 832 041
US-A- 3 526 002

(73) Proprietor: The Secretary of State for Defence
in Her Britannic Majesty's Government of the
United Kingdom of Great Britain and
Northern Ireland Whitehall
London SW1A 2HB (GB)

(72) Inventor: THEOBALD, Alan, George 40 Park
Estate Road
Portland
Dorset DTS 2BL (GB)

(74) Representative: Beckham, Robert William et al
Procurement Executive Ministry of Defence
Patents 1A(4), Room 2014
Empress State Building Lillie Road London
SW6 1TR (GB)

## Description

This invention relates to a self-ranging system for measuring the magnetic signature of a ship enabling compensatory adjustements to be made to a degaussing system. By this means the risk to the ship in traversing a minefield can be reduced.

Most naval vessels are fitted with degaussing systems which afford a degree of protection against sea mines and magnetic sensors. These degaussing systems initially have to be calibrated and then periodically checked and adjusted. The calibration and checking measurements are conventionally carried out at degaussing ranges. The degaussing system may be carried onboard as a permanent arrangement or there maybe coils and magnets for temporary off-board use as disclosed in UK patent No 2142781, published 23 January 1985. There are a number of different types of degaussing ranges, the most common being the open degaussing range. This comprises a number of magnetometer units (usually about 18) on a framework on the sea bed which are connected by cable to shore based instrumentation. A vessel is required to sail over one or two of these underwater arrays on reciprocal headings. From the information gained, the amount of adjustement required can be calculated so as to give minimum residual fields and to enable a forecast of the system settings in other latitudes to be made.

This forecast makes two assumptions, both associated with the permanent vertical magnetism content of the vessel. The amount of permanent vertical magnetism present cannot be determined from the measurements in one latitude - a substantial variation in the vertical component of the Earth's magnetic intensity is required, leading to a need for degaussing ranges at widely different latitudes. The available maximum variation of magnetic intensity in the UK, between Scotland and the South Coast, is insufficient for an assessment of the permanent vertical magnetism of a ship. Therefore, an empirical ratio of permanent to total vertical magnetization of the vessel, based upon modelwork, is assumed. If the vessel sails to another latitude and stays there for some time, say six months or more, the permanent vertical magnetism will change towardsd the equilibrium value for the new area.

The permanent horizontal magnetization comprises athwartships and longitudinal components. On a long voyage which is basically on one heading there will be variation in both of these components, but primarily in the longitudinal component. This is due to the continuous vibration of the ship's hull in the Earth's magnetic field. This effect causes the degaussing compensation applied at the degaussing range at the home port to become incorrect.

Thus, there is a need for a degaussing range to be available at the end of a voyage to another latitude.

This second range measurement will check the compensation of the vertical and horizontal magnetization and allows the compensation to be adjusted accordingly.

As permanent magnetic measurement facilities are not available worldwide, a mobile degaussing facility is required. In the past, transportable degaussing ranges have been used for some of these purposes. The transportable ranges have been similar to the fixed open degaussing ranges. The sensor framework, of about 18 sensors, is placed on the seabed by divers and is connected to a land-based, moveable instrumentation unit. Thus these ranges have major disadvantages in the support and time required for deployment and recovery.

UK Patent No. 2177511 published 16 December 1987 proposed a portable magnetic self-ranging system enabling a ship to readily determine its own degaussing compensation in areas where open degaussing ranges are not available.

It is a requirement of known arrangements for determining a ship's magnetic signature that the ship's tracking system provides ships positional information relative to the magnetic sensors used in the magnetic ranging systems. Suitable algorithms are then used to find a best fit to the observed measurements. Various tracking systems have been devised which can be used to provide ship's positional information relative to magnetic sensors. EP 0133408 concerns a course plotting system for a naval vessel which comprises magnetic radiation emitter fitted to the vessel and lying on the sea-bed two triaxial magnetometers. This system enables establishment of the course of a ship which has been degaussed or is to be degaussed against magnetic detection.

The object of the present invention is to provide a simplified magnetic self-ranging system which overcomes the necessity for a ship's tracking system.

The invention provides a ship's magnetic self-ranging system which comprises:

a) at least one magnetometer assembly for placement on the sea-bed;

b) a telemetry link to transfer magnetic data from the magnetometer assembly to a surface receiver;

c) a surface receiver for collection of the magnetic data;

d) computer means to process the data; and

e) means for adjusting the ships degaussing system to minimise the ship's magnetic field; characterised in that

f) a pair of buoys is provided to define the extent of the magnetometer assembly; and

g) a computer means to process the magnetic data, the computer means having stored therein a model representing the ship's magnetic field as a magnetic source defined by both continuous and distributed discrete point sources along finite length, parallel straight lines, in the vicinity of, if not within, the physical source, the model being used to process the magnetic data received from the magnetometer assembly to provide information for the adjustment of the ship's degaussing system.

Preferably the magnetometer assembly comprises at least two magnetometer packages with each package containing at least one 3-axis magnetic sensor. Each sensor should be sensitive to about 10 nano-Tesla with a dynamic range of about ± 200,000 nano-Tesla.

The processing of the data collected from the ranging system according to the present invention depends upon the assumptions firstly that the ship follows a constant heading and a constant speeed and secondly that the ship can be characterised by a magnetic model.
Advantageously the distributed point sources of the magnetic model are uniformly spaced and the density distribution function of the continuous sources is defined by a polynomial. Since magnetic fields are linear in the point source components and in the polynomial coefficients, these variables are readily determined using linear least squares regression analysis. Alternatively other distribution functions can be defined for the continuous source, such as a combination of harmonic or Bessel functions of increasing order. The functions are selected such that the fields are linear in the function order coefficients, making the model easily usable.

Experience has shown that a steel ship can be acceptably modelled using a dipole-order source defined by a 6th to 8th order polynomial, independent in each dipole axis, along a single rectilinear line with no point sources.

Preferably there are at least two magnetometer packages and separation of the magnetometers is between one and two times the water depth and their relative position is known to within 1%. The orientation of the magnetometers should preferably be known to within 1 degree as should the bearing of each from the others. Advantageously the magnetometers may be rigidly attached to a common bar. In addition the marker buoys are preferably attached to physically separate sinkers.

At the end of a ship's run over the deployed self-ranging system the computer means is arranged to determine an appropriate magnetic source model from which magnetic fields over the sea-bed plane can be determined so that the ship's degaussing can be adjusted.

Ships would be required to traverse the facility passing midway between the two marker buoys, following a straight track at a constant speed at right angles to a line joining the two buoys. Since ship's speed has no effect on its magnetic field and the fastest speed is likely to result in the straightest track, the ship should sail as fast as safety allows. The magnetometer sampling interval should be adjustable to allow readings to be taken at least every 1 metre of the ship's track.

According to a further embodiment of the present invention there is provided a method of degaussing a ship by means of a magnetic self-ranging system comprising the steps of:

a) deploying at least one magnetic sensor assembly on the seabed;

b) sailing the ship at a constant speed and heading over the magnetic assembly using the buoys for guidance;

c) transferring magnetic data from the magnetometer assembly to a surface receiver via a telemetry link on one of the buoys;
characterised in that

d) a pair of buoys is provided to define the extent of the magnetometer assembly on the seabed ; and

d) an appropriate magnetic source model of the ship is computed which is defined by a combination of continuous and distributed discrete point sources along finite length, straight lines parallel to the ship's longitudinal axis and in the vicinity of if not within the boundary defined by the ship; the magnetic source model being used in processing the magnetic data from the magnetometer assembly so that appropriate adjustement to the currents in the ship's degaussing coils to minimise the ship's magnetic field can be made. Other aspects of this method will be apparent from the description.

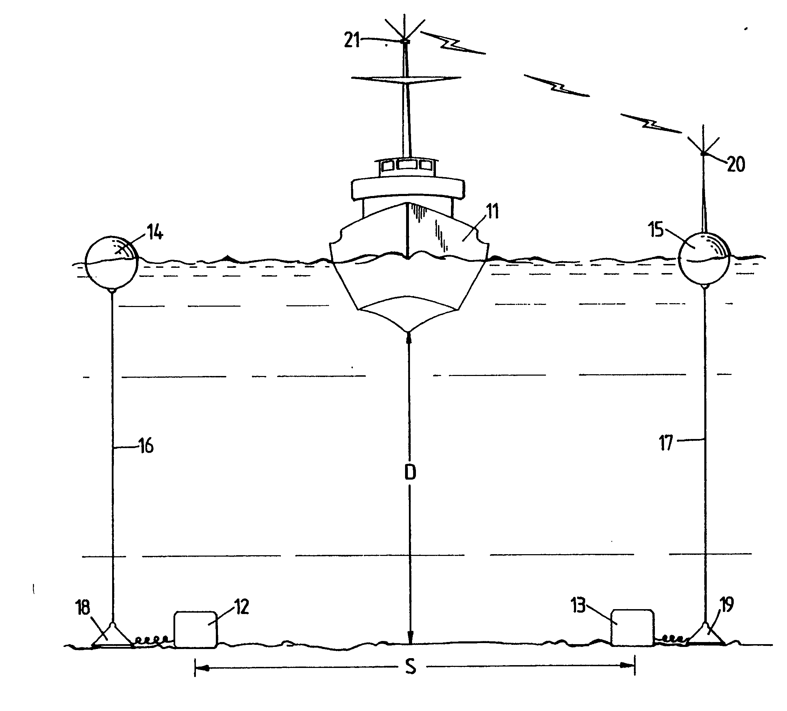

The invention will now be described by way of example only with reference to the accompanying Drawing which shows a deployed magnetic self-ranging system.

A ship 11 operating in the vicinity of minefields typically willl carry between ten and thirty independent degaussing coils. In addition it carries a magnetic self-ranging system comprising magnetometer packages 12, 13 for sea-bed deployment to enable adjustements to be made to the degaussing coils so as to substantially cancel the ship's magnetic field. The self-ranging system comprises at least two magnetometer packages 12, 13 whose orientation is accurately known on the sea-bed at a separation S which is between one and two times the depth D. Each magnetometer package 12, 13 is attached to a respective marker buoy 14, 15 connected by cables 16, 17 to sinkers 18, 19. The sinkers and attached buoys are placed such that they define the outer extremities of the combined magnetometer package array. Each magnetometer in the array is connected to a receiver/transmitter located on the buoy 15. The receiver/transmitter is arranged to collect and transmit the magnetometer data continuously during passage of the ship over the self-ranging system. The data is transmitted via antennas 20 and antenna 21 respectively on the buoy 15 and the ship to a receiver which is part of a data collection and processing facility.

Each magnetometer is a 3-axis magnetometer, thus providing 3 x Nn magnetic measurements where N is the number of magnetometers and n is the number of measurements received from each magnetometer channel.

The processing of the magnetometer data is carried out assuming that the relative positions and orientations of the magnetometers are known and also that the relative position of the ship can be described with reference to alinear ship's path travelled at constant speed. By this means the magnetic observations must be sufficient to provide a solution for just four additional unknown parameters: that is the relative location of any given sensor with respect to the ship-based co-ordinate system, given in terms of 3-axial co-ordinate offsets, and the ship's effective "magnetic" length.

The ship is required to travel a known straight course at right angles to and approximately bisecting the array axis defined by the two buoys 14, 15. Since ship's speed has no effect on its magnetic field and the fastest speed is likely to result in the straightest track, the ship should sail as fast as safety allows. The sampling rate of the magnetometers is adjusted such that readings are taken at least every metre of the ship's track. The ship's data processing facility utilises a magnetic model capable of predicting the magnetic field over an area typically greater in extent than that expected to be provided by a transportable magnetic self-ranging system. This predicted field is then used to determine the optimum setting for the degaussing system.

The magnetic model used characterises the ship's magnetic field by continuous and distributed discrete point sources along finite length parallel straight lines in the vicinity of the ship. Given a set of magnetic field measurements, there is a need to infer a set of appropriate source parameters and decay laws so that the magnetic field may subsequently be predicted, with a reasonable accuracy expectation, at points other than where it is measured. A source model has been devised which is a reasonable representation of reality, especially for a source which has a large length to breadth ratio.

The "conventional" method of modelling a magentic source, from field measurements, is to assume that the source can be approximated by a series of point dipoles. In the near-field regime, where the source dimensions are comparable to or larger than the measurement distance, such a solution can produce significant errors in predicted magnetic fields in addition to the "ringing" of dipole amplitudes unless specific steps are taken to prevent the latter. The model proposes that a source utilises higher order multipoles and/or an extended source. In addition, there is a consistent method of detemining the optimum location of such a source(s). Analysis shows that for a magnetic source comprising a set of (hypothetical) monopoles the magnetic field is equivalent to that from an expansion of multipole moments. As an extension to this an arbitrary distribution of point multipoles can be expressed as an expansion of multipoles of higher orders. The magnetic fields from higher order terms may be determined through recurrance relations from lower order terms. The magnetic field measurements can then be used to detemine a model source distribution of higher order terms. A modification to the model can be made by supposing that the source is extended, where the magnetic source (multipole) density distribution is defined along a finite length line parallel to the longitudinal axis of the ship. The magnetic field resulting from this extended source has been shown to be linear in the polynomial coefficients so that the coefficients can be readily determined.

The optimum location for the above multipole sources is best determined by a non-linear iterative technique, where knowledge of at least the first derivative of the field, with respect to the appropriate parameters, is advised. For the point multipole, this derivative is readily determined since it has the same spatial dependence as the appropriate field of the next order multipole. Further, for a set of uniformly spaced multipoles parallel to the ship's longitudinal axis the derivative of the field with repect to the multipole spacing is also readily determinable. In addition the same treatment can be applied to multipoles equally spaced in the mutually perpendicular directions to provide a source "mesh".

The continuous source model should provide a more realistic (physically) approach to modelling a complex source, since an inherent feature is the resultant smoothness of the source distribution function as defined by a polynomial, circumventing the dipole "ringing" feature mentioned earlier. Furthermore, by defining the problem in terms of arbitrary order multipoles, the model is likely to be effective at ranges considerably less than the length of a source with a large length-to-breadth ratio, for example a steel ship. Experience has shown that a steel ship can be acceptably modelled using a dipole-order source defined by a 6th to 8th order polynomial, independent in each dipole axis, along a single rectilinear line with no point sources. Furhter experience has shown that the solution so obtained was, to a great extent, independent of the estimated starting values assigned to the positional offset and source length as required for the non-linear regression analysis. Thus ship's tracking information is not required since it is not used in obtaining the solutions. This was found to be especially true when data from more than one magnetometer was used. In addition, the magnetic source so determined is capable of reproducing the observed field with increasing faithfulness as more magnetometers, and also more data in general, is used. The magnetic packages measuring the ship's field could contain single axis magnetometers, however this would provide only a third of the data from 3-axis magnetometers for defining the ship's magnetic model.

The self-ranging system could be arranged such that the telemetry buoy 15 collects all the magnetic field data from a ship's run before transmission to the ship. After collecting the run data the ship's computer facility then determines the appropriate model: discrete source and/or extended source from which field over a plane would be determine. This is then used to reset the degaussing coils to minimise the field in that plane.

## Claims

1. A ship's magnetic self-ranging system which comprises:
   a) at least one magnetometer assembly for placement on the seabed;
   b) a telemetry link to transfer magnetic data from the magnetometer assembly to a surface receiver;
   c) a surface receiver for collection of the magnetic data;
   d) computer means to process the data; and
   e) means for adjusting the ships degaussing system to minimise the ship's magnetic field;
   characterised in that
   f) a pair of buoys is provided to define the extent of the magnetometer assembly; and
   g) a computer means to process the magnetic data, the computer means having stored therein a model representing the ship's magnetic field as a magnetic source defined by both continuous and distributed discrete point sources along finite length, parallel straight lines, in the vicinity of, if not within, the physical source, the model being used to process the magnetic data received from the magnetometer assembly to provide information for the adjustment of the ship's degaussing system.

2. A ship's magnetic self-ranging system as claimed in claim 1 characterised in that the magnetometer assembly comprises at least two magnetometer packages (12, 13) with each package containing at least one 3-axis magnetic sensor.

3. A ship's magnetic self-ranging system as claimed in claim 2 characterised in that each sensor is sensitive to about 10 nano-Tesla with a dynamic range of about ± 200,000 nano-Tesla.

4. A ship's magnetic self-ranging system as claimed in claim 1 characterised in that the distributed point sources of the model are uniformly spaced and the density distribution function of the continuous sources is defined by a polynomial.

5. A ship's magnetic self-ranging system as claimed in claim 4 characterised in that the ship's computer means is arranged to determine an appropriate magnetic source model from which magnetic fields over the seabed plane can be determined so that a degaussing system for the ship can be adjusted.

6. A ship's magnetic self-ranging system as claimed in claim 4 or 5 characterised in that the ship's magnetic field is modelled using a dipole-order source defined by a 6th to 8th order polynomial, independent in each dipole axis, along a single rectilinear line with no point sources.

7. A method of degaussing a ship by means of a magnetic self-ranging system comprising the steps of:
   a) deploying at least one magnetic sensor assembly (12) on the seabed;
   b) sailing the ship (11) at a constant speed and heading over the magnetic assembly using the buoys for guidance;
   c) transferring magnetic data from the magnetometer assembly to a surface receiver via a telemetry link on one of the buoys;
   characterised in that
   d) a pair of buoys (14,15) is provided to define the extent of the magnetic sensor assembly on the seabed; and
   e) an appropriate magnetic source model of the ship is computed which is defined by a combination of continuous and distributed discrete point sources along finite length, straight lines parallel to the ship's longitudinal axis and in the vicinity of if not within the boundary defined by the ship; the magnetic source model being used in processing the magnetic data from the magnetometer assembly so that appropriate adjustement to the currents in the ship's degaussing coils to minimise the ship's magnetic field can be made.

8. A method of degaussing a ship as claimed in claim 7 characterised in that the magnetometer assembly comprises at least two magnetometer packages (12,13), with each package containing as least one 3-axis magnetic sensor.

9. A method of degaussing a ship as claimed in claim 8 characterised in that the magnetometer packages are deployed such that the separation between the magnetic sensors is between one and two times the water depth and their relative position is known to within 1%.

10. A method of degaussing a ship as claimed in claim 9 characterised in that the orientation of the magnetometers is determined to within 1 degree.

11. A method of degaussing a ship as claimed in claim 7 characterised in that there is included the further step of collecting the magnetic data during passage of the ship over the magnetic assembly before transferring to the surface receiver.

12. A method of degaussing a ship as claimed in claim 7 or 11 characterised in that there is included the step of sailing the ship at the fastest safe speed along a course at right angles to a line joining the two buoys and intersecting the line substantially midway between the buoys.

13. A method of degaussing a ship as claimed in claim 7 or 11 characterised in that there is included the step of sampling the magnetometers at a rate corresponding to the passage of each meter length of the ship over the magnetic assembly.

**Patentansprüche**

1. Magnetisches Selbstjustiersystem für Schiffe, das umfaßt:

a) mindestens einen Magnetometeraufbau zur Anordnung auf dem Meeresgrund,

b) eine Datenfernübertragungsverbindung zur Übertragung von Magnetfeldinformationsdaten von dem Magnetometeraufbau zu einem Empfänger an der Wasseroberfläche,

c) einen Empfänger an der Wasseroberfläche zur Aufnahme der Magnetfeldinformationsdaten,

d) Datenverarbeitungsmittel zur Verarbeitung der Daten, und

e) Mittel zum Einstellen des magnetischen Selbstjustiersystems zur Minimierung des Einflusses des Schiffsmagnetfelds,

dadurch gekennzeichnet, daß

f) zwei Bojen zur Kennzeichnung des Magnetometeraufbaus vorgesehen sind, und

g) Computermittel zur Verarbeitung der Magnetfeldinformationsdaten ein Modell des Schiffsmagnetfelds gespeichert haben, das magnetische Quelldaten enthält, die durch kontinuierlich und verteilt angeordnete diskrete Quellpunkte entlang finiter Längen, parallel durchgehenden Linien, gebildet sind, nahe oder innerhalb des physikalischen Ursprungs, wobei das Modell zur Verarbeitung der von dem Magnetometeraufbau empfangenen Magnetfeldinformationsdaten zur Einstellung des magnetischen Selbstjustierssystems des Schiffs verwendet wird.

2. Magnetisches Selbstjustiersystem nach Anspruch 1, dadurch gekennzeichnet, daß der Magnetometeraufbau mindestens zwei Magnetometerbaugruppen (12, 13) enthält, wobei jede Baugruppe mindestens einen 3-achsigen magnetischen Sensor umfaßt.

3. Magnetisches Selbstjustiersystem nach Anspruch 2, dadurch gekennzeichnet, daß jeder Sensor eine Meßgenauigkeit von ca. 10 nT besitzt mit einem Dynamikbereich von ca. ± 200 000 nT.

4. Magnetisches Selbstjustiersystem für Schiffe nach Anspruch 1, dadurch gekennzeichnet, daß die verteilt angeordneten Quellpunkte des Modells gleichmäßig beabstandet sind und die Dichteverteilungsfunktion der kontinuierlich angeordneten Quellpunkte als Polynom definiert sind.

5. Magnetisches Selbstjustiersystem nach Anspruch 4, dadurch gekennzeichnet, daß die Computermittel des Schiffs zur Bestimmung eines geeigneten magnetischen Quellenmodells ausgelegt sind, aus dem magnetische Felder der Ebene des Meeresgrunds bestimmt werden, so daß ein magnetisches Selbstjustiersystem für das Schiff einjustiert werden kann.

6. Magnetisches Selbstjustiersystem für Schiffe nach Anspruch 4 oder 5, dadurch gekennzeichnet, daß das Magnetfeld des Schiffes unter Verwendung einer Dipolquelle modelliert ist, die durch ein Polynom der 6. bis 8. Ordnung beschrieben werden kann, und zwar unabhängig in jeder Dipolachse entlang einzelner geradlinig verlaufender Linien ohne Quellpunkte.

7. Verfahren zum magnetischen Selbstjustieren von Schiffen durch ein magnetisches Selbstjustiersystem mit folgenden Schritten:

a) Aufstellen mindestens eines magnetischen Sensoraufbaus (12) auf dem Meeresgrund,

b) Bewegen des Schiffs (11) mit einer konstanten Geschwindigkeit und mit einem über den magnetischen Aufbau führenden Kurs, wobei die Bojen zur Orientierung verwendet werden, und

c) Übertragen von Magnetfeldinformationsdaten des Magnetometeraufbaus zu einem Empfänger an der Wasseroberfläche durch eine Datenfernübertragungsverbindung an einer der Bojen,

dadurch gekennzeichnet, daß

d) zwei Bojen (14, 15) zur Kennzeichnung des sich auf dem Meeresgrund befindenden magnetischen Sensoraufbaus vorgesehen sind, und

e) ein geeignetes magnetisches Quellenmodell des Schiffs ausgearbeitet wird, das durch eine Kombination von kontinuierlich und verteilt angeordneten diskreten Punkten entlang finiter Längen, durchgehenden Linien, die zur Längsachse des Schiffs parallel sind und nahe oder innerhalb des Schiffsrumpfs angeordnet sind, definiert ist, wobei das magnetische Quellenmodell bei der Verarbeitung der Magnetfeldinformationsdaten des Magnetometeraufbaus zur geeigneten Anpassung der Induktionsströme in den Neutralisierungsspulen verwendet wird, zur Minimierung des Einflusses des Schiffsmagnetfelds.

8. Verfahren nach Anspruch 7, dadurch gekennzeichnet, daß der Magnetometeraufbau mindestens zwei Magnetometerbaugruppen (12, 13) enthält, wobei jede Baugruppe mindestens einen 3-achsigen magnetischen Sensor enthält.

9. Verfahren nach Anspruch 8, dadurch gekennzeichnet, daß die Magnetometerbaugruppen derart aufgebaut werden, daß der Abstand zwischen den magnetischen Sensoren der ein- bis zweifachen Wassertiefe entspricht und deren relative Lage mit 1 %-iger Genauigkeit bekannt ist.

10. Verfahren nach Anspruch 9, dadurch gekennzeichnet, daß die Ausrichtung der Magnetometer auf 1° genau erfolgt.

11. Verfahren nach Anspruch 7, dadurch gekennzeichnet, daß, währenddem sich das Schiff über den Magnetometeraufbau bewegt, weitere Schritte zur Erfassung der Magnetfeldinformationsdaten vorgesehen sind, vor der Übertragung zu dem an der Oberfläche befindlichen Empfänger.

12. Verfahren nach Anspruch 7 oder 11, dadurch gekennzeichnet, daß das Schiff mit der größtmöglichen Geschwindigkeit auf einem Kurs bewegt wird, der rechtwinklig zur Verbindungslinie der beiden Bojen angeordnet ist und der diese Linie im wesentlichen mittig zwischen den Bojen schneidet.

13. Verfahren nach Anspruch 7 oder 11, dadurch gekennzeichnet, daß die Abtastrate des Magnetometeraufbaus derart eingestellt wird, daß für jeden Meter Schiffsbewegung über den Magnetometeraufbau eine Abtastung durchgeführt wird.

## Revendications

1. Système de télémesure magnétique automatique pour navires, ce système comprenant:

a) au moins un ensemble de magnétométric destiné à être mis en place sur le fond de la mer;

b) un relais de télémétrie destiné au transfert de données magnétiques provenant de l'ensemble de magnétométrie, jusqu'à un récepteur en surface;

c) un récepteur en surface, destiné à recueillir les données magnétiques;

d) des moyens de calcul ou ordinateur(s) destinés au traitement des données;

et e) des moyens destinés au réglage du système de démagnétisation du navire afin de réduire à un minimum le champ magnétique du navire;

système caractérisé en ce que:

f) une paire de bouées est installée dans le but de délimiter la zone d'extension de l'ensemble de magnétométrie; et

g) le système comprend un moyen de calcul destiné au traitement des données magnétiques, le moyen de calcul comportant dans sa mémoire un modèle représentant le champ magnétique du navire, en tant que source magnétique, définie à la fois par des sources continues et par des sources constituées par des points séparés répartis sur des lignes droites parallèles de longueur finie, à proximité de la source physique, éventuellement à l'intérieur de celle-ci, le modèle étant utilisé pour traiter les données magnétiques reçues à partir de l'ensemble de magnétométrie afin de fournir des informations destinées au réglage du système de démagnétisation du navire.

2. Système de télémétrie magnétique selon la revendication 1, caractérisé en ce que l'ensemble de magnétométrie comporte au moins deux sous-ensembles (12, 13) de magnétométrie, chaque sous-ensemble comportant au moins un capteur magnétique à trois axes.

3. Système de télémétrie magnétique selon la revendication 2, caractérisé en ce que chacun des capteurs est sensible à environ 10 nano-teslas, avec une gamme dynamique de ± 200 000 nano-teslas.

4. Système de télémétrie magnétique selon la revendication 1, caractérisé en ce que les sources ponctuelles situées en différents endroits du modèle sont uniformément réparties et en ce que la fonction de distribution de la densité des sources continues est définie par un polynôme.

5. Système de télémétrie magnétique selon la revendication 4, caractérisé en ce que le moyen de calcul ou ordinateur du navire est agencé en vue de déterminer un modèle de source magnétique approprié, à partir duquel les champs magnétiques existant au-dessus du plan du fond de la mer peuvent être déterminés de façon telle qu'un système de démagnétisation du navire puisse être réglé.

6. Système de télémétrie selon la revendication 4 ou 5, caractérisé en ce que le modèle du champ magnétique du navire est obtenu à l'aide d'une source d'ordre dipolaire, définie par un polynôme d'ordre 6 à 8 indépendant dans chaque axe de dipôle, sur une seule ligne rectiligne ne comportant pas de sources ponctuelles.

7. Procédé de démagnétisation d'un navire au moyen d'un système de télémétrie magnétique automatique, le procédé comportant les opérations suivantes:

a) disposer au moins un ensemble (12) formant capteur magnétique, sur le fond de la mer;

b) faire avancer le navire (11) à vitesses constante, en maintenant un cap pour passer au-dessus de l'ensemble magnétique, en utilisant les bouées pour se diriger;

c) transférer les données magnétiques, à partir de l'ensemble de magnétométrie, jusqu'à un récepteur de surface par l'intermédiaire d'un relais de télémétrie situé sur l'une des bouées, procédé caractérisé en ce que

d) une paire de bouées (14, 15) est installée en vue de définir la zone d'extension de l'ensemble de magnétométrie sur le fond de la mer,

et e) un modèle de source magnétique approprié du navire est calculé, lequel est défini par une combinaison de sources continues et de sources constituées par des points séparés répartis sur des lignes droites de longueur finie parallèles à l'axe longitudinal du navire et à proximité de la limite définie par le navire, sinon même à l'intérieur de celle-ci, le modèle de source magnétique étant utilisé pour le traitement des données magnétiques provenant de l'ensemble de magnétométrie, de façon telle que l'on puisse réaliser un réglage approprié des courants électriques passant dans les bobines de démagnétisation, afin de réduire à un minimum le champ magnétique du navire.

8. Procédé de démagnétisation automatique d'un navire selon la revendication 7, caractérisé en ce que l'ensemble de magnétisation comporte au moins deux sous-ensembles (12, 13) de magnétométrie, chaque sous-ensemble comportant au moins un capteur magnétique à trois axes.

9. Procédé de démagnétisation d'un navire selon la revendication 8, caractérisé en ce que les sous-ensembles de magnétométrie sont disposés de façon telle que la dimension de l'intervalle entre les capteurs magnétiques se situe entre une à deux fois la profondeur de l'eau et en ce que la position relative des capteurs est connue à 1 % près.

10. Procédé de démagnétisation d'un navire, selon la revendication 9, caractérisé en ce que l'orientation des magnétomètres est déterminée à 1 degré près.

11. Procédé de démagnétisation d'un navire selon la revendication 7, caractérisé en ce qu'il comprend l'opération supplémentaire consistant à recueillir les données magnétiques pendant le passage du navire au-dessus de l'ensemble magnétique, avant de tranférer les données au récepteur en surface.

12. Procédé de démagnétisation d'un navire selon la revendication 7 ou 11, caractérisé en ce qu'il comporte l'opération consistant à faire avancer le navire à la plus grande vitesse possible sans nuire à la sécurité, sur un trajet formant un angle droit avec la ligne qui joint les bouées et intersectant la ligne sensiblement à mi-chemin entre les bouées.

13. Procédé de démagnétisation d'un navire selon la revendication 7 ou 11, caractérisé en ce qu'il comporte l'opération consistant à recueillir les données des magnétomètres à une cadence correspondant au passage de chaque mètre parcouru par le navire au-dessus de l'ensemble de magnétométrie.

EP 0 242 391 B1